# FASCICULE DE BREVET EUROPEEN

(11) **EP 1 537 660 B1**
(45) Date de publication et mention de la délivrance du brevet: **14.11.2007**
(21) Numéro de dépôt: 03750455.2
(22) Date de dépôt: 28.08.2003
(51) Int. Cl.: H03J 1/00

(54) **PROCEDE DE COMMANDE D UN APPAREIL MULTIMEDIA POUR VEHICULE A UTOMOBILE ET APPAREIL METTANT EN OEUVRE CE PROCEDE**
BETRIEBSVERFAHREN UND VORRICHTUNG FÜR EIN MULTIMEDIA-EMPFANGSGERÄT FÜR KRAFTFAHRZEUGE
METHOD OF CONTROLLING A MULTIMEDIA DEVICE FOR A MOTOR VEHICLE AND A DEVICE IMPLEMENTING SAID METHOD

(30) Priorité: 11.09.2002 FR 0211217
(43) Date de publication de la demande: 08.06.2005
(73) Titulaire: Siemens VDO Automotive, 31036 Toulouse (FR)
(72) Inventeur: RINGOT, Nicolas, F-91410 Dourdan (FR)
(74) Mandataire: Berg, Peter
(86) Numéro de dépôt international: PCT/EP2003/009505
(87) Numéro de publication internationale: WO 2004/025834

(56) Documents cités:
- EP-A- 0 347 686
- EP-A- 0 893 750
- WO-A-02/39712
- WO-A-99/27435
- DE-A- 10 056 307
- DE-A- 19 747 284
- DE-A- 19 807 410

## Description

La présente invention vise un procédé de commande d'un appareil multimédia pour véhicule automobile ainsi qu'un tel appareil mettant en oeuvre ce procédé. Elle s'applique, en particulier aux autoradios et/ou systèmes de navigation.

Le problème général auquel la présente invention tente de répondre est de fournir un moyen de commande / de sélection des différentes fonctions de l'appareil, qui soit le plus intuitif possible, et pour l'opération duquel la distraction du conducteur soit minimisée afin de ne pas avoir d'impact négatif sur la sécurité de conduite.

Le document EP 0 893 750 décrit un appareil multimédia, comportant un écran graphique et un bouton rotatif qui possède la possibilité d'un mouvement bi-axial (haut/bas - droite/gauche).

On connaît les documents WO 99/22447 et EP 0347 686. Ces deux documents proposent l'utilisation un bouton rotatif dont la manoeuvre en rotation dans un sens ou dans l'autre fournit à l'appareil des impulsions (éventuellement assorties d'une indication du sens de rotation) servant à sélectionner une fonction ou à régler un paramètre de cette fonction, la commutation entre le mode de sélection de fonction et le mode de réglage s'effectuant par action selon une troisième direction, par exemple en poussant sur le bouton (exemple : sélection du volume parmi fonctions volume, balance, graves, aigus, etc. puis réglage de l'intensité sonore après enfoncement - fugitif ou non - du bouton). Ce dispositif présente l'inconvénient d'absorber l'attention du conducteur pour déterminer dans quel mode (sélection / réglage) se trouve le dispositif.

La présente invention entend remédier à ces inconvénients. A cet effet, la présente invention vise un procédé de commande, du type utilisant un écran graphique et un bouton bi-axial (haut/bas - droite/gauche) caractérisé en ce que l'action sur le bouton bi-axial dans un premier axe sélectionne une fonction dans un menu déroulant affiché sur ledit écran graphique et bouclé sur lui-même, et l'action sur le bouton bi-axial dans le second axe permet le réglage d'un paramètre de la fonction sélectionnée.

Grâce à ces dispositions, l'utilisateur choisit, sur le premier axe, la fonction qu'il souhaite sélectionner et règle ensuite, sur le second axe, un paramètre de cette fonction. Le réglage est ainsi rapide et ne sollicite que très peu l'attention de l'utilisateur.

Selon des caractéristiques particulières, la fonction sélectionnée apparaît, en permanence, au centre du menu déroulant. Grâce à ces dispositions, la fonction sélectionnée est aisément identifiable et elle est entourée des fonctions les plus proches dans le menu déroulant.

Selon des caractéristiques particulières, le menu déroulant se présente sous la forme d'un cylindre ou tambour d'axe horizontal vu latéralement. Grâce à ces dispositions, le sens de rotation du tambour peut correspondre à un axe du bouton bi-axial.

La présente invention vise aussi un appareil multimédia mettant en oeuvre le procédé tel que succinctement exposé ci-dessus, dans lequel le bouton bi-axial est situé sur l'appareil ou déporté.

D'autres avantages, buts et caractéristiques de la présente invention ressortiront de la description qui va suivre, faite en regard du dessin annexé dans lequel :
- la figure 1 représente une face avant d'un dispositif mettant en oeuvre un mode particulier de réalisation de la présente invention ;
- les figures 2 à 6 représentent des images affichées sur un écran illustré en figure 1, conformément à différents modes de fonctionnement du dispositif illustré en figure 1.

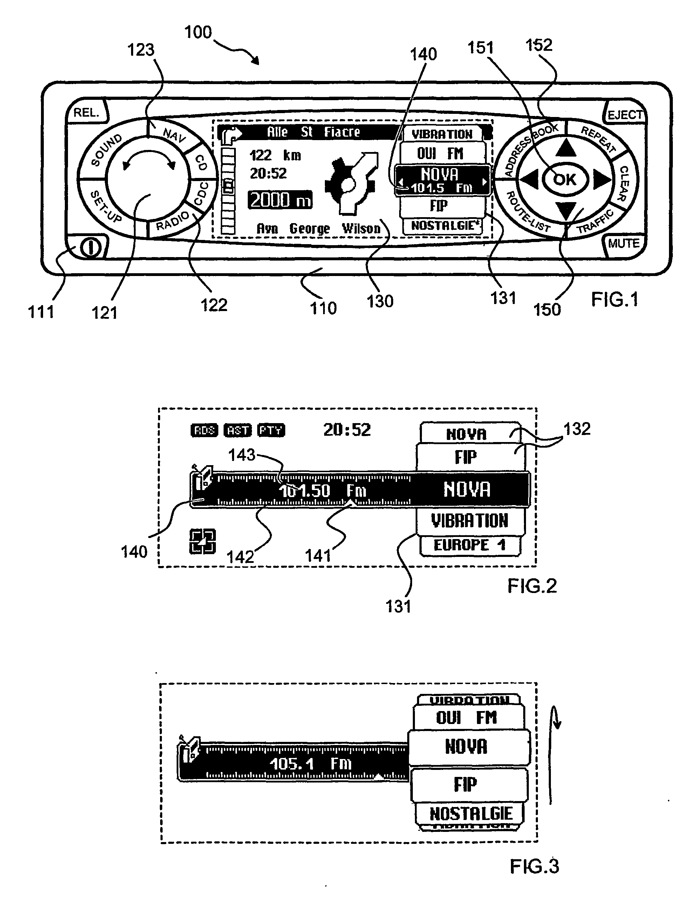

On observe, en figure 1, une face avant 110 d'un appareil multimédia 100, en l'occurrence un autoradio intégrant des fonctions d'aide à la navigation, comportant un écran 130, un bouton bi-axial 150, quatre boutons de coin dont par exemple un bouton de marche-arrêt 111, un bouton de validation 151 central par rapport au bouton bi-axial 150, cinq boutons 152, périphériques au bouton bi-axial 150, un bouton rotatif 121 de réglage du volume sonore et six boutons de sélection de mode (par exemple sélection de mode "RADIO" 122 ou "NAVIGATION" 123) situés autour du bouton rotatif 121.

La face avant 110 de l'appareil multimédia est électriquement reliée à des circuits électroniques (non représentés) qui fournissent des fonctions de navigation, d'autoradio, de téléphonie, ou de lecteur de disques compact ou de cassettes audio, par exemple. La face avant 110 possède les dimensions normalisées d'une face avant d'autoradio.

Les quatre boutons de coin correspondent chacune à une fonction spécifique qui ne possède pas de variable. Par exemple, le bouton de coin 111 correspond à la commande "marche-arrêt" de l'appareil, le bouton de coin "EJECT" à la fonction d'éjection d'un compact disque, le bouton de coin "MUTE" pour arrêter toute émission sonore faite par l'appareil multimédia, et le bouton de -coin "REL." (abréviation de "release" pour "détacher") permet l'ouverture de la façade du poste.

Les six boutons de sélection de mode correspondent respectivement aux modes de fonctionnement suivants de l'appareil multimédia 100 :
- "NAV" (bouton 123) permet de sélectionner le mode d'assistance à la navigation,
- "CD" permet de sélectionner le mode lecture d'un compact disque inséré dans une fente de l'appareil multimédia 100,
- "CDC" qui permet de sélectionner le mode lecture d'un disque compact stocké dans un magasin comportant une pluralité de disques compacts,
- "RADIO", (bouton 122) permet de sélectionner le mode écoute d'une radio,
- "SET-UP", qui permet de sélectionner des paramètres d'utilisation générale de l'appareil multimédia 100, et
- "SOUND" qui permet l'accès à un menu de réglage du son : tonalité, balance, etc.

Selon les modes de réalisation, le bouton bi-axial 150 de l'appareil multimédia 100 peut être soit situé sur l'appareil lui-même, soit déporté. Le bouton bi-axial 150 présente deux axes munis chacun de deux boutons placés dans des directions opposées. Un des axes est vertical et l'autre horizontal. Le bouton 151 central au bouton bi-axial 150 permet de valider certains choix effectués par l'utilisateur par l'intermédiaire du bouton bi-axial 150, comme expliqué ci-dessous.

Les cinq boutons 152, périphériques au bouton bi-axial 150, correspondent respectivement aux fonctions suivantes du système de navigation incorporé à l'appareil multimédia 100 :
- "ADDRESS-BOOK", donnant accès à un carnet d'adresses géographiques utilisées pour la navigation,
- "REPEAT", donnant accès à une répétition du dernier message vocal diffusé par le système d'aide à la navigation,
- "CLEAR", permettant d'effacer la sélection de destination ou la sélection de lieu d'origine,
- "TRAFFIC", permettant de visualiser des information de trafic routier et
- "ROUTE-LIST", permettant de choisir une route.

L'écran 130 est un écran graphique, par exemple à cristaux liquides. Il est adapté à afficher les images illustrées aux figures 1 à 6, soit de manière monochrome, soit en couleur. Dans chacune de ces figures, on observe :
- un menu déroulant 131 bouclé sur lui-même, c'est-à-dire que lors de son défilement vertical prolongé (commandé par l'action sur le bouton bi-axial 150, selon l'axe vertical), les fonctions réapparaissent cycliquement à une extrémité du menu déroulant 131, défilent et disparaissent à l'autre extrémité du menu déroulant.
- une barre de réglage 140 s'étendant perpendiculairement au menu déroulant 131 et intégrale avec l'indication de la fonction et permettant le réglage d'un paramètre de la fonction sélectionnée dans le menu déroulant.

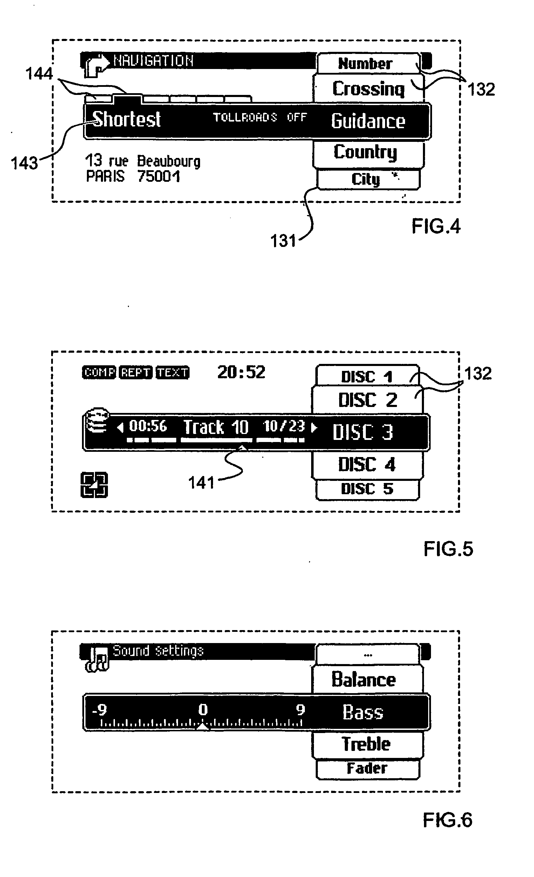

Dans les modes de réalisation illustrés sur les figures 1 à 6, le menu déroulant 131 se présente sous la forme d'un cylindre ou d'un tambour d'axe horizontal, vu latéralement, et dont la surface visible se décompose en facettes 132 portant-chacune l'indication d'une fonction dépendant du mode de fonctionnement choisi. Par exemple, sur les figures 1 à 3, où le mode de fonctionnement est l'écoute de la radio, le menu déroulant permet la sélection d'une station de radio (fonction) et chaque facette porte le nom d'une station de radio préréglée. Sur la figure 4, où le mode de fonctionnement est la navigation, le menu déroulant permet la sélection d'une fonction telle que le guidage, l'entrée de données de destination, etc. et chaque facette porte une indication de cette fonction. De même, sur la figure 5, en mode d'écoute de disques compacts, chaque facette représente un des disques du magasin, ou sur la figure 6, en mode de réglage du son, chaque facette correspond à une des fonctions graves, aigus, balance, etc.

La fonction sélectionnée reste au centre de la partie apparente du menu, lors de son défilement, par exemple dans le troisième intervalle lorsque cinq intervalles sont représentés. De plus, la fonction sélectionnée est préférentiellement affichée en vidéo inversée, c'est à dire en blanc sur fond noir. En outre, en appliquant un effet de perspective, comme si les fonctions étaient écrites sur un cylindre ou un tambour d'axe horizontal vu latéralement, on donne aux fonctions non sélectionnées qui entourent la fonction sélectionnée une importance visuelle moindre que celle de la fonction sélectionnée tout en les maintenant affichées afin que l'utilisateur repère aisément les fonctions successives qu'il pourrait sélectionner.

Le menu déroulant 131 est commandé par l'action de l'utilisateur sur le bouton bi-axial 150, préférentiellement par action dans l'axe vertical de celui-ci. Lorsque l'utilisateur appuie sur la touche basse du bouton bi-axial 150, il fait tourner le menu déroulant / cylindre de fonctions vers le haut, ce qui a pour effet de rendre centrale et de sélectionner la fonction qui apparaissait précédemment en dessous de la fonction centrale sélectionnée. Réciproquement, lorsque l'utilisateur appuie sur la touche haute du bouton bi-axial 150, il fait tourner le menu déroulant / cylindre de fonctions vers le bas, ce qui a pour effet de rendre centrale et de sélectionner la fonction qui apparaissait précédemment au dessus de la fonction centrale sélectionnée. Ce processus de sélection peut être agrémenté d'une animation visuelle donnant l'impression d'une rotation du tambour, comme représenté en figure 3. Dans ce cas, pendant la rotation du tambour, toutes les facettes sont rendues en vidéo normale, jusqu'à ce qu'une nouvelle fonction soit sélectionnée. Alors, la facette 132 correspondante sera de nouveau affichée en vidéo inversée.

Lorsqu'une fonction est sélectionnée, une barre de réglage 140 permettant le réglage d'un paramètre de la fonction choisie sur le menu déroulant, s'étend latéralement sur l'écran 130, perpendiculairement à l'axe de défilement du menu, pour afficher les valeurs du paramètre qui peuvent être sélectionnées en utilisant les touches droite et gauche du bouton bi-axial 150.

Selon les modes de fonctionnement, l'apparence du menu déroulant / cylindre de fonctions 131 et de la barre de réglage 140 change. Ainsi, lorsqu'il n'y a qu'un mode de fonctionnement à afficher sur l'écran, par exemple parce que le système d'assistance à la navigation n'est pas en service ou qu'il ne requiert pas l'attention immédiate du conducteur, comme illustré en figures 2 à 6, la description de la fonction et de son paramètre principal est plus étendue sur l'écran 130 que lorsque deux modes de fonctionnement sont affichés simultanément sur le même écran, comme illustré en figure 1. Lorsque l'utilisateur met en oeuvre deux modes de fonctionnement simultanément (par exemple une application audio et une application de navigation), la valeur du paramètre de la fonction choisie dans le menu déroulant 131 est affichée dans ledit menu déroulant, par exemple juste en dessous de la description textuelle ou de l'icône de la fonction sélectionnée. La barre de réglage 140 se situe alors sous l'indication de la fonction, de manière simplifiée. Le reste de l'écran 130 est utilisé pour l'affichage de la fonction d'assistance à la navigation.

Lorsqu'un seul mode de fonctionnement est affiché, la barre de réglage 140 s'étend sur toute la largeur de l'écran, dans le prolongement de la facette correspondant à la fonction sélectionnée et intégrale avec celle-ci. Elle est donc représentée en vidéo inversée. Le réglage du paramètre s'effectue au moyen d'une action sur le bouton bi-axial 150, selon l'axe perpendiculaire à l'axe permettant le défilement du menu déroulant, c'est à dire préférentiellement l'axe horizontal. Selon la fonction sélectionnée, le réglage peut être continu, par une pression maintenue sur les touches droite ou gauche du bouton bi-axial 150, comme dans l'exemple de réglage d'une fréquence d'une station de radio illustré sur la figure 2. Dans ce cas, le réglage est matérialisé par le déplacement d'un curseur 141 sur une échelle graduée 142, dans le sens correspondant à la touche actionnée. Un affichage alphanumérique 143, situé au centre de la barre de réglage 140, permet le réglage précis, ainsi que l'affichage d'informations complémentaires telles que la gamme de fréquence utilisée. Le réglage peut également s'effectuer de manière discrète, comme illustré à la figure 4, par pressions brèves successives sur les touches de l'axe horizontal du bouton bi-axial 150, pour sélectionner un onglet 144 représentant une option prédéterminée parmi une liste de choix possibles pour la fonction considérée, l'identification de l'option pouvant être affichée sur l'affichage alphanumérique 143. Une combinaison des modes de réglage discret et continu peut aussi être employée, comme dans l'exemple de la lecture d'un disque compact illustré à la figure 5, où des pressions brèves permettent de sélectionner la piste du disque à lire, identifiée sur l'affichage alphanumérique 143, au centre de la barre de réglage 140, et des pressions longues permettent l'avance ou le retour rapide du faisceau de lecture à l'intérieur de la piste sélectionnée, la position du faisceau étant matérialisée par celle du curseur 141.

Selon des variantes, la valeur sélectionnée du paramètre (y compris lorsqu'il s'agit d'une sous-fonction) reste au milieu de la barre de réglage 140 ou de l'intervalle de valeurs de paramètre représenté. La nouvelle valeur de paramètre est, en général, automatiquement mise en oeuvre. Cependant, dans certains cas, en particulier pour les choix effectués pour l'aide à la navigation, l'appui sur le bouton central 111 ("OK" pour validation) du bouton bi-axial 150 sert à valider un choix d'une valeur de paramètre.

Bien que les figures soient, par nature, statiques, on observe que, conformément à des variantes des modes de réalisation de la présente invention, chaque élément graphique affiché sur l'écran graphique 130, et, en particulier, la barre de réglage, peut présenter une animation.

L'appareil multimédia 100 objet de la présente invention affiche ainsi les deux niveaux de commande principaux dans une structure à deux axes correspondant aux deux axes du bouton bi-axial 150, générant ainsi une relation logique et étroite entre l'information affichée et les deux axes de commande matérialisés par les deux axes du bouton bi-axial 150. De cette manière, l'utilisateur visualise, sur l'écran 130, deux niveaux de commande qu'il contrôle directement par l'intermédiaire du bouton bi-axial 150. Il peut sélectionner une fonction, en pressant l'un des boutons correspondant à l'axe vertical du bouton bi-axial 150 jusqu'à ce que la fonction désirée apparaisse au milieu du menu déroulant, et régler une nouvelle valeur d'un paramètre de la fonction sélectionnée, en pressant l'un des boutons correspondant à l'axe horizontal du bouton bi-axial 150.

Dans le mode de réalisation représenté, toutes les fonctions audio sont contrôlées par l'intermédiaire des deux axes du menu déroulant 131 et du bouton bi-axial 150, et l'utilisateur n'utilise que ce type d'interface, facile à appréhender et à maîtriser, et demandant moins d'attention pendant les phases de conduite.

La présente invention donne ainsi à l'utilisateur un accès direct et explicite aux divers niveaux de commande requis par les applications multimédias évoquées ici.

## Revendications

1. - Procédé de commande d'un appareil multimédia, du type utilisant un écran graphique (130) et un bouton bi-axial (150) (haut/bas - droite/gauche) **caractérisé en ce que** l'action sur le bouton bi-axial dans un premier axe sélectionne une fonction dans un menu déroulant (131) affiché sur ledit écran graphique et bouclé sur lui-même, et l'action sur le bouton bi-axial dans le second axe permet le réglage d'un paramètre de la fonction sélectionnée.

2. - Procédé selon la revendication 1, **caractérisé en ce que** la fonction sélectionnée apparaît, en permanence, au centre du menu déroulant (131).

3. - Procédé selon l'une quelconque des revendications 1 ou 2, **caractérisé en ce que** le menu déroulant (131) se présente sous la forme d'un cylindre ou tambour d'axe horizontal vu latéralement.

4. - Procédé selon l'une quelconque des revendications 1 à 3, **caractérisé en ce que**, une fois la fonction sélectionnée, la plage de réglage du paramètre apparaît sous la forme d'une barre de réglage (140) s'étendant perpendiculairement au menu déroulant (131) et intégrale avec l'indication de la fonction.

5. - Procédé selon la revendication 4, **caractérisé en ce que**, pour au moins une fonction, la barre de réglage (140) se présente sous la forme d'un curseur (141) sur une échelle graduée (142).

6. - Procédé selon la revendication 4, **caractérisé en ce que**, pour au moins une fonction, la barre de réglage (140) se présente sous la forme d'une série d'onglets (144).

7. - Procédé selon l'une quelconque des revendications 1 à 6, **caractérisé en ce que**, si le reste de l'écran est occupé par l'affichage d'une seconde fonction, la barre de réglage (140) se situe sous l'indication de la fonction, de manière simplifiée.

8. - Procédé selon l'une quelconque des revendications 1 à 7, **caractérisé en ce que**, dans ledit menu déroulant (131), des fonctions non sélectionnées présentent une importance visuelle moindre que la fonction sélectionnée, tout en étant maintenues affichées.

9. - Procédé selon l'une quelconque des revendications 1 à 8, **caractérisé en ce que**, dans ledit menu déroulant (131), la fonction sélectionnée apparaît en vidéo inversée par rapport aux autres fonctions.

10. - Appareil multimédia (100) mettant en oeuvre le procédé selon l'une quelconque des revendications 1 à 9, **caractérisé en ce que** le bouton bi-axial (150) -est situé sur l'appareil ou déporté.

## Claims

1. Method of controlling a multimedia apparatus, of the type using a graphic display screen (130) and a bi-axial button (150) (up/down - right/left)
**characterised in that** actuation of the bi-axial button in a first axis selects a function in a scrolling menu (131) displayed on said graphic display screen and in a continuous loop, and actuation of the bi-axial button in the second axis is used for adjusting a parameter of the selected function.

2. Method according to claim 1,
**characterised in that** the selected function appears permanently in the centre of the scrolling menu (131).

3. Method according to claim 1 or claim 2,
**characterised in that** the scrolling menu (131) is in the form of a cylinder or drum with a horizontal axis when viewed laterally.

4. Method according to one of claims 1 to 3,
**characterised in that**, when the function has been selected, the range of adjustment of the parameter appears in the form of an adjustment bar (140) extending perpendicular to the scrolling menu (131) and being integral with the indication of the function.

5. Method according to claim 4,
**characterised in that**, for at least one function, the adjustment bar (140) is in the form of a cursor (141) on a graduated scale.

6. Method according to claim 4,
**characterised in that**, for at least one function, the adjustment bar (140) is in the form of a series of tabs (144).

7. Method according to one of claims 1 to 6, **characterised in that**, if the rest of the screen is occupied by the display of a second function, the adjustment bar (140) appears in simplified form under the function indication.

8. Method according to one of claims 1 to 7, **characterised in that**, in said scrolling menu (131), the unselected functions have a lesser visual prominence than the selected function but remain displayed.

9. Method according to one of claims 1 to 8,
**characterised in that**, in said scrolling menu (131), the selected function appears in reverse video compared to the other functions.

10. A multimedia apparatus using the method according to one of claims 1 to 9,
**characterised in that** the bi-axial button (150) is located on the apparatus or remotely therefrom.

## Patentansprüche

1. Betriebsverfahren für ein Multimedia-Empfangsgerät des Typs, der ein Graphikdisplay (130) und einen biaxialen Knopf (150) (oben/unten - rechts/links) verwendet, **dadurch gekennzeichnet, dass** die Betätigung des biaxialen Knopfes auf einer ersten Achse eine Funktion in einem Pull-down-Menü (131) auswählt, das auf dem Graphikdisplay angezeigt ist und ein Schleifenmenü ist, und die Betätigung des biaxialen Knopfes auf der zweiten Achse das Einstellen eines Parameters der ausgewählten Funktion ermöglicht.

2. Verfahren nach Anspruch 1, **dadurch gekennzeichnet, dass** die ausgewählte Funktion dauerhaft in der Mitte des Pull-down-Menüs (131) erscheint.

3. Verfahren nach einem der Ansprüche 1 oder 2, **dadurch gekennzeichnet, dass** das Pull-down-Menü (131) die Form eines Zylinders oder einer Trommel mit einer horizontalen Achse seitlich gesehen aufweist.

4. Verfahren nach einem der Ansprüche 1 bis 3, **dadurch gekennzeichnet, dass**, sobald die Funktion ausgewählt ist, der Einstellbereich des Parameters die Form einer Einstellleiste (140) aufweist, die sich senkrecht zum Pull-down-Menü (131) erstreckt und mit der Funktionsanzeige ein Teil bildet.

5. Verfahren nach Anspruch 4, **dadurch gekennzeichnet, dass**, für mindestens eine Funktion, die Einstellleiste (140) die Form eines Schiebers (141) auf einer Skala (142) aufweist.

6. Verfahren nach Anspruch 4, **dadurch gekennzeichnet, dass**, für mindestens eine Funktion, die Einstellleiste (140) die Form einer Serie von Reitern (144) aufweist.

7. Verfahren nach einem der Ansprüche 1 bis 6, **dadurch gekennzeichnet, dass**, wenn der Rest des Displays durch die Anzeige einer zweiten Funktion eingenommen wird, die Einstellleiste (140) auf vereinfachter Weise unter der Funktionsanzeige liegt.

8. Verfahren nach einem der Ansprüche 1 bis 7, **dadurch gekennzeichnet, dass** in dem Pull-down-Menü (131) nicht ausgewählte Funktionen eine geringere visuelle Bedeutung als die ausgewählte Funktion aufweisen, wobei sie angezeigt bleiben.

9. Verfahren nach einem der Ansprüche 1 bis 8, **dadurch gekennzeichnet, dass** in dem Pull-down-Menü (131) die ausgewählte Funktion in invertierter Darstellung im Gegensatz zu den anderen Funktionen erscheint.

10. Multimedia-Empfangsgerät (100), das das Verfahren nach einem der Ansprüche 1 bis 9 einsetzt, **dadurch gekennzeichnet, dass** der biaxiale Knopf (150) auf dem Gerät oder abseits liegt.
